# EUROPEAN PATENT APPLICATION

(11) **EP 4 510 798 A1**
(43) Date of publication of application: **19.02.2025**
(21) Application number: 23788030.7
(22) Date of filing: 21.02.2023
(51) Int. Cl.: H05K 9/00, H01L 23/427, H05K 7/20

(54) **ELECTRONIC DEVICE**

(30) Priority: 11.04.2022 JP 2022065382
(71) Applicant: Sony Interactive Entertainment Inc., Tokyo 108-0075 (JP)
(72) Inventor: MORISHITA, Mitsuharu, Tokyo 108-0075 (JP); SUGAWARA, Nobuyuki, Tokyo 108-0075 (JP); YANAGIHARA, Hisao, Tokyo 108-0075 (JP); NOZAWA, Tetsufumi, Tokyo 108-0075 (JP)
(74) Representative: D Young & Co LLP
(86) International application number: PCT/JP2023/006290
(87) International publication number: WO 2023/199607

(57) **Abstract**

Provided is an electronic device in which a degree of freedom in layout of electronic components on a circuit board can be increased and leakage of noise can be suppressed. A heat pipe (50, 150) extends to the outside of an upper board shield (30, 130) through an opening (32, 132) that is formed in the upper board shield. An auxiliary shield (80, 180) is fitted to the upper board shield (30, 130), and covers the opening (32, 132) in the upper board shield (30, 130).

## Description

### [Technical Field]

The present disclosure relates to an electronic device.

### [Background Art]

In a certain electronic device, a heat pipe is used to dissipate heat generated in an electronic component mounted on a circuit board. In an electronic device described in PTL 1, a plurality of fins (heat sinks) are fitted to a heat pipe, and heat is radiated from the heat sinks.

Further, in electronic devices, noise countermeasures (EMI (Electro Magnetic Interference) countermeasures) have been taken to shield noise coming from a chip mounted on a circuit board or a data transmission path. In an electronic device described in PTL 2 below, an edge of a board shield covering a circuit board is in contact with a ground pattern disposed on an outer peripheral portion of the circuit board so that leakage of noise to the outside of the circuit board shield is suppressed.

### [Citation List]

### [Patent Literature]

[PTL 1]
   WO 2021/193621
[PTL 2]
   JP 2018-148026A

### [Summary]

### [Technical Problem]

If a heat pipe is disposed along a circuit board, it is difficult to maintain a sufficient distance between an electronic component and a heat pipe. Accordingly, it is difficult to mount an electronic component in this area.

An object of the present disclosure is to provide an electronic device in which the degree of freedom in layout of electronic components on a circuit board can be increased, and leakage of noise can be suppressed.

### [Solution to Problem]

An electronic device according to the present disclosure includes a circuit board, a circuit board shield covering the circuit board, a heat pipe disposed between the circuit board and the circuit board shield; and
an auxiliary shield, in which an opening is formed in the circuit board shield, the heat pipe extends from a space between the circuit board and the circuit board shield to an outside of the circuit board shield through the opening, and the auxiliary shield is fitted to the circuit board shield, and covers the opening. Accordingly, the degree of freedom in layout of electronic components on the circuit board can be increased, and leakage of noise can be suppressed.

### [Brief Description of Drawings]

[FIG. 1A]

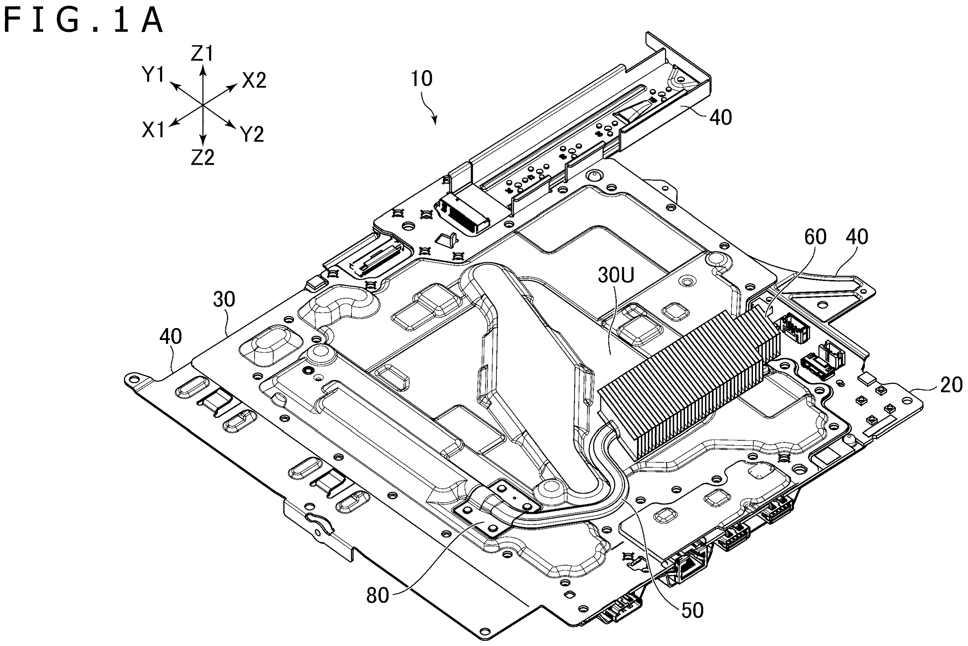

   FIG. 1A is a perspective view of a circuit board unit that is disposed inside an electronic device which is one example of an embodiment of the present disclosure.
[FIG. 1B]

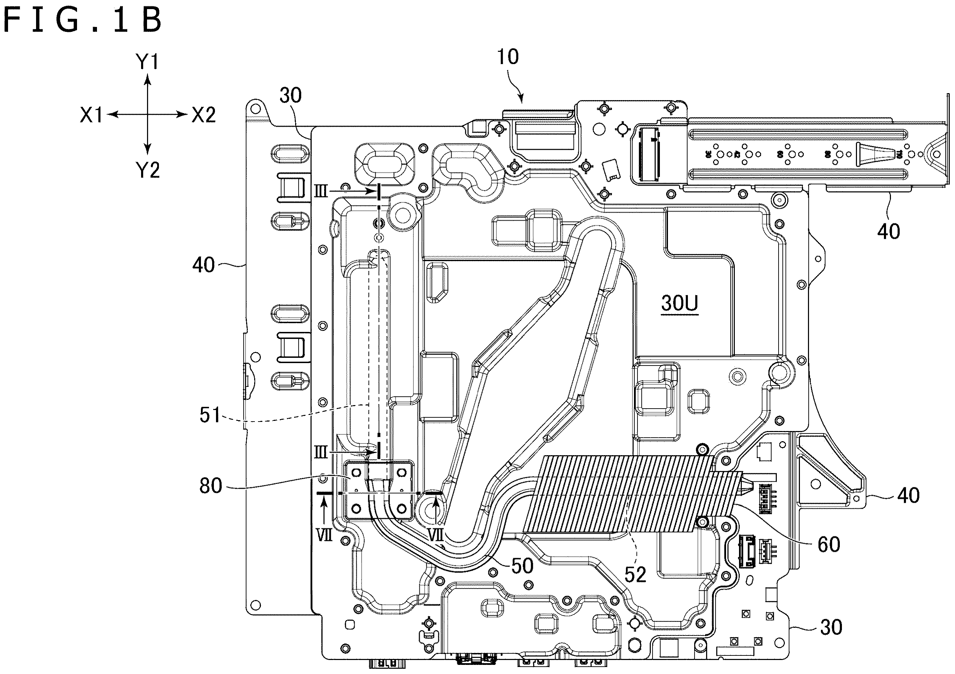

   FIG. 1B is a plan view of the circuit board unit.
[FIG. 2]

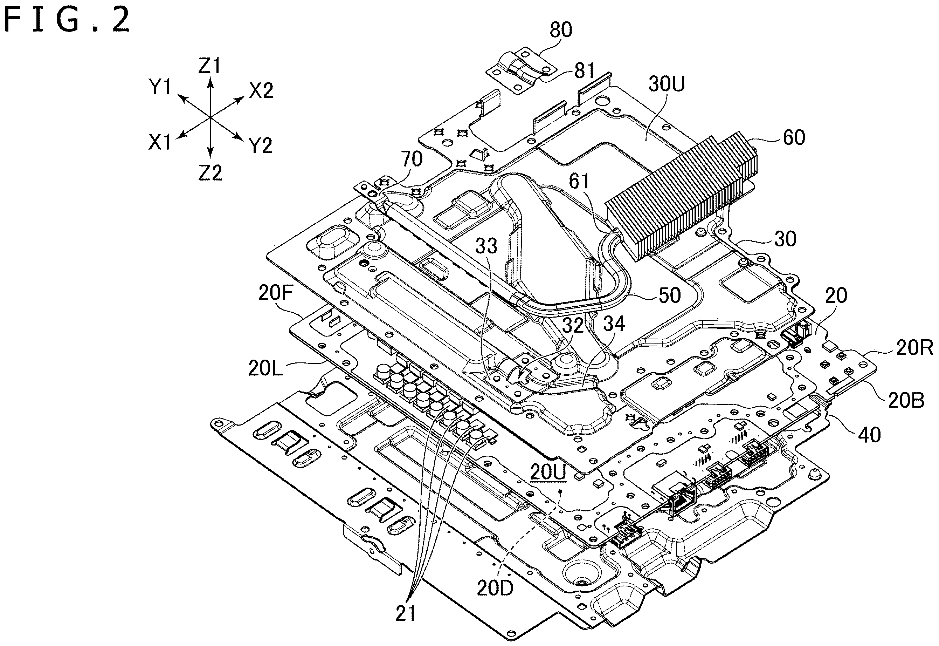

   FIG. 2 is an exploded perspective view of the circuit board unit.
[FIG. 3]

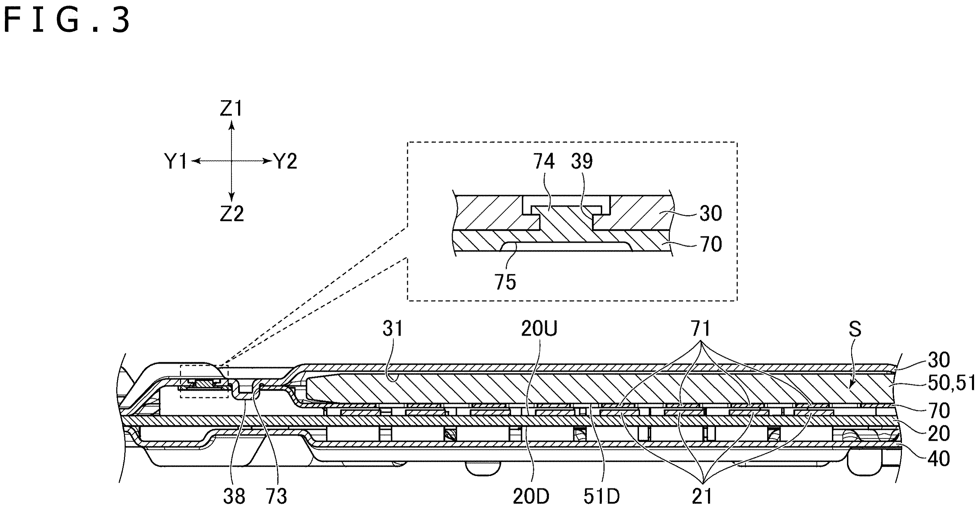

   FIG. 3 is a sectional view taken along line III-III in FIG. 1B.
[FIG. 4]

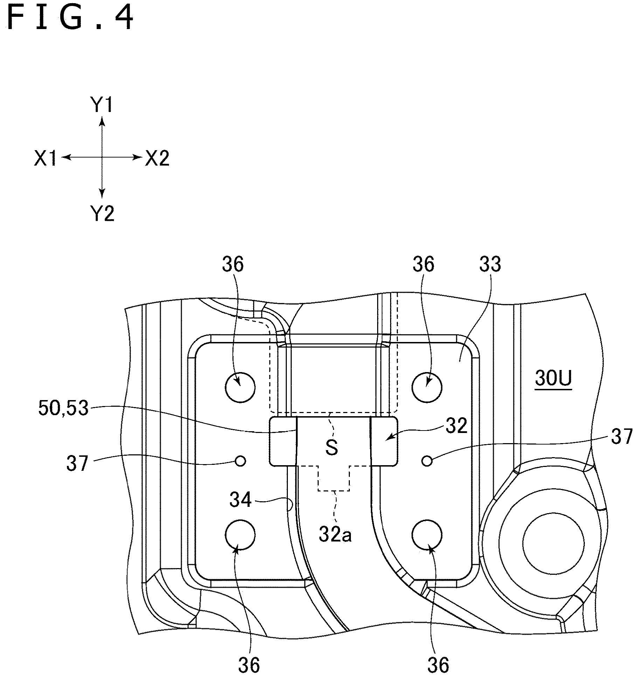

   FIG. 4 is a diagram depicting an area around an opening in an upper board shield.
[FIG. 5]

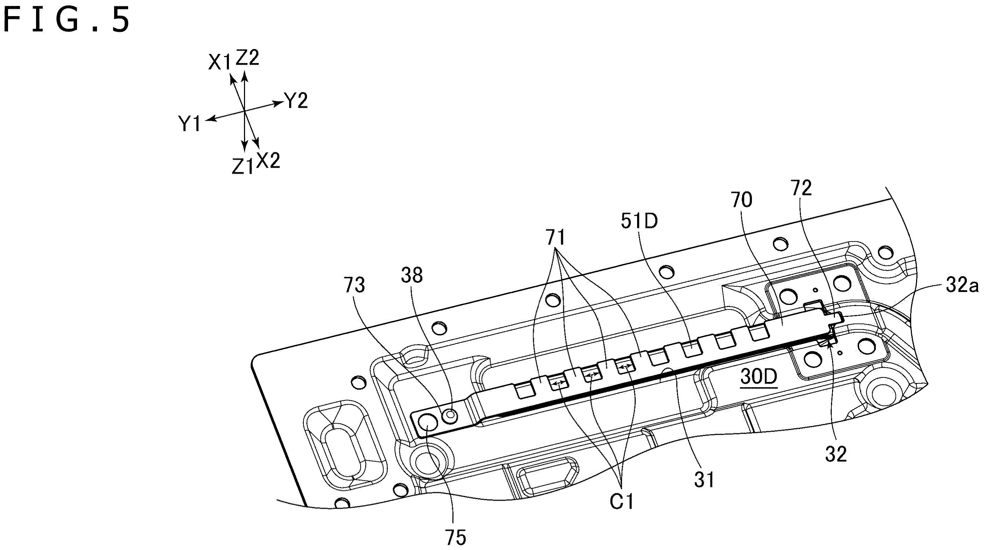

   FIG. 5 is a perspective view of the rear side of the upper board shield.
[FIG. 6]

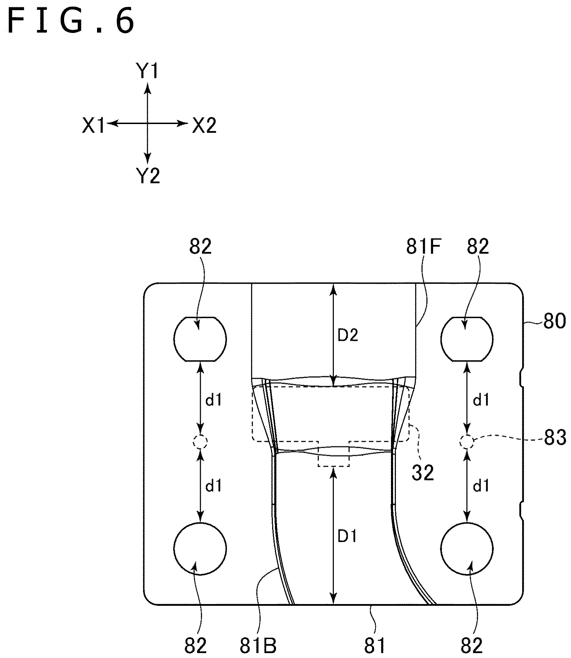

   FIG. 6 is a plan view of an auxiliary shield.
[FIG. 7]

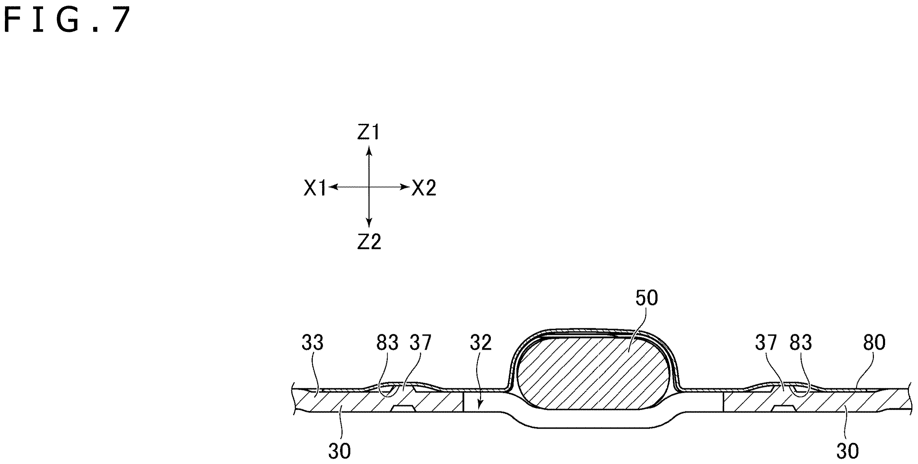

   FIG. 7 is a sectional view taken along line VII-VII in FIG. 1B, and schematically depicts a cross section of the upper board shield and the auxiliary shield.
[FIG. 8]

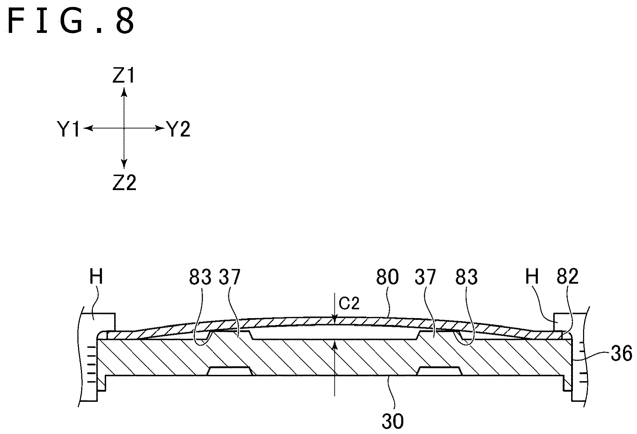

   FIG. 8 schematically depicts a cross section of the upper board shield and the auxiliary shield according to another example of the present embodiment.
[FIG. 9]

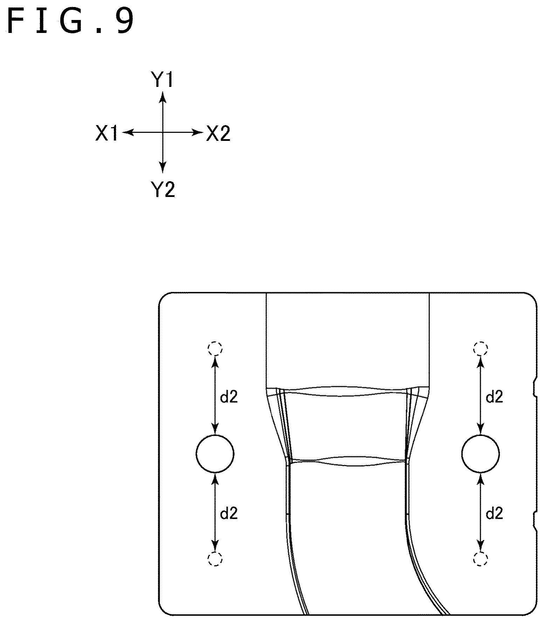

   FIG. 9 is a plan view of the auxiliary shield according to the other example of the present embodiment.
[FIG. 10]

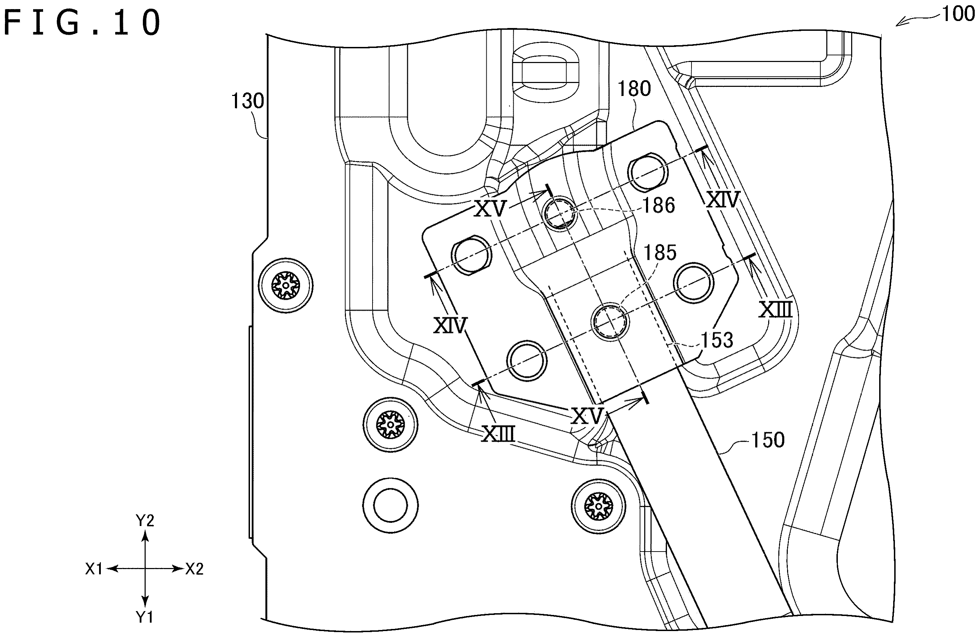

   FIG. 10 is a plan view of a part of a circuit board unit disposed inside an electronic device which is another example of an embodiment of the present disclosure.
[FIG. 11]

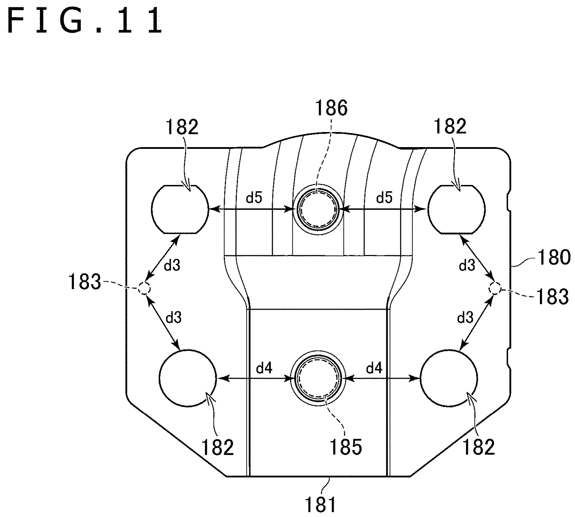

   FIG. 11 is a plan view of the auxiliary shield.
[FIG. 12]

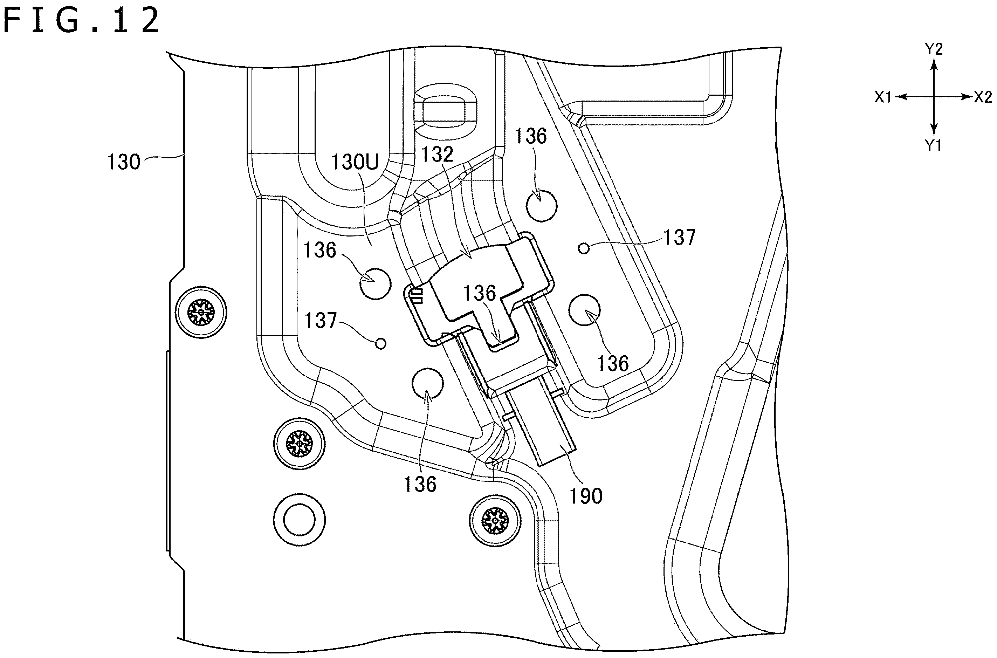

   FIG. 12 is a plan view of the upper board shield from which the auxiliary shield has been removed.
[FIG. 13]

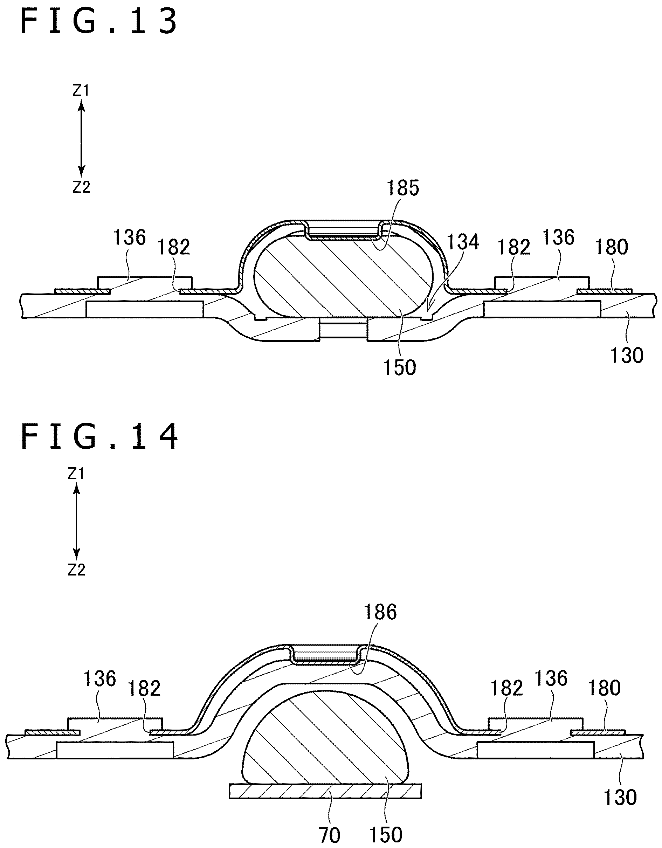

   FIG. 13 is a sectional view taken along line XIII-XIII in FIG. 10.
[FIG. 14]
   FIG. 14 is a sectional view taken along line XIV-XIV in FIG. 10.
[FIG. 15]

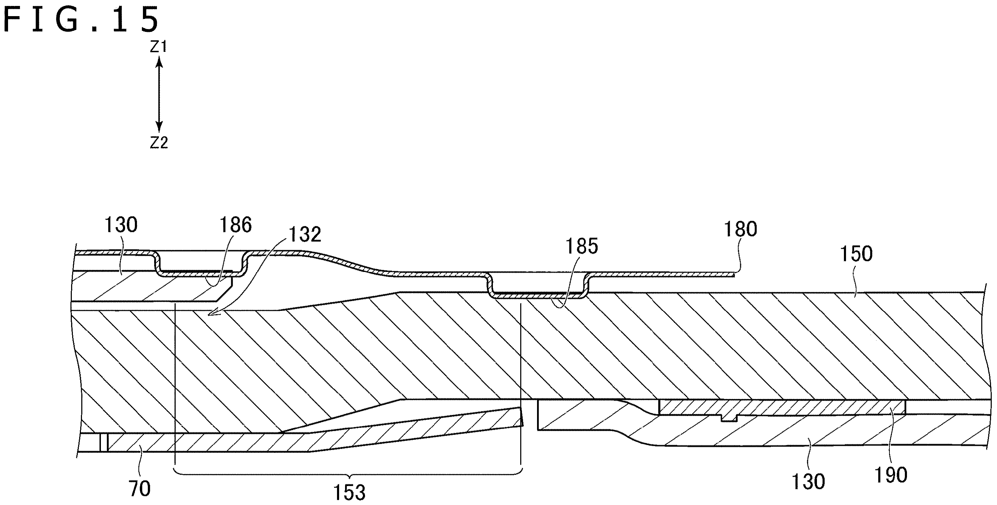

   FIG. 15 is a sectional view taken along line XV-XV in FIG. 10.

### [Description of Embodiments]

### [1. First embodiment]

### [1-1. Outline of Circuit board unit]

FIG. 1A is a perspective view of a front side (upper side) of a circuit board unit 10 disposed inside an electronic device which is one example (first embodiment) of an embodiment of the present disclosure. FIG. 1B is a plan view of the circuit board unit 10. FIG. 2 is an exploded perspective view of elements constituting the circuit board unit 10. As depicted in the drawings, the circuit board unit 10 includes a circuit board 20, a first circuit board shield 30, and a second circuit board shield 40. As depicted in FIG. 2, the circuit board 20 has a flat shape, and has a first surface 20U and a second surface 20D (see FIG. 3) opposite to the first surface. The first circuit board shield 30 covers the first surface 20U of the circuit board 20. The second circuit board shield 40 covers the second surface 20D of the circuit board 20.

In the following explanation, a Z1 direction and a Z2 direction in a Z axis, which are depicted in FIG. 2, etc., are referred to as an up direction and a down direction, respectively. Further, the first surface 20U of the circuit board 20 is referred to as an upper surface 20U, and the second surface 20D of the circuit board 20 is referred to as a lower surface 20D. The first circuit board shield 30 is referred to as an upper board shield 30, and the second circuit board shield 40 is referred to as a lower board shield 40. In addition, in the following description, the circuit board 20 includes outer edges 20F and 20D along an X axis, and outer edges 20R and 20L along a Y axis depicted in FIG. 2, etc. An X1 direction and an X2 direction in the X axis depicted in FIG. 2, etc., are referred to as a left direction and a right direction, respectively. A Y1 direction and a Y2 direction in the Y axis are referred to as a front direction and a rear direction, respectively. The outer edge 20F on the front side, the outer edge 20D on the rear side, the outer edge 20L on the left side, and the outer edge 20R on the right side of the circuit board 20, may be referred to as a front edge 20F, a rear edge 20D, a left edge 20L, and a right edge 20R, respectively. However, these directions and arrangement positions are defined to explain the shapes and the relative positional relation of elements including the components, the members, and the portions of the circuit board unit 10, and are not intended to specify the direction of the circuit board unit 10 in the electric apparatus.

### [1-2. Internal structure of circuit board unit]

As depicted in FIG. 2, electronic components including a plurality of chips 21 and the like are mounted also on the upper surface 20U of the circuit board 20. Also, a plurality of electronic components (not depicted) are mounted on the lower surface 20D of the circuit board 20. From these electronic components or data transmission paths, noise such as an electromagnetic wave is generated. The upper board shield 30 and the lower board shield 40 (hereinafter, also simply referred to as board shields 30 and 40) are provided to suppress leakage of noise generated on the circuit board 20 to the outside of the circuit board unit 10. The upper board shield 30 and the lower board shield 40 cover the upper surface 20U and the lower surface 20D of the circuit board 20, respectively. Each of the board shields 30 and 40 can be produced by performing sheet metal processing such as drawing processing on a conductive metal sheet including iron, aluminum, or the like. The board shields 30 and 40 are fixed to the circuit board 20 with a fitting tool such as a screw or a rivet.

In addition, as depicted in FIG. 2, the circuit board unit 10 includes a heat pipe 50 extending into a rod-like shape along the circuit board 20, and a heat sink 60 fitted to the heat pipe. The heat pipe 50 and the heat sink 60 are used to cool the plurality of chips 21, and are formed from metal such as aluminum, copper, or stainless having high heat conductivity. By being pressed against a member (e.g., a cover or a frame) constituting the electronic device, which is not depicted, the heat sink 60 may be fixed to an upper surface 30U which is the front-side surface of the upper board shield 30. Alternatively, the heat sink 60 may be fixed to the upper surface 30U of the upper board shield 30 by soldering or the like.

It is to be noted that the plurality of chips 21 of the present embodiment are transistors such as FETs (Field Effect Transistors) that generate power for driving a processor mounted on the circuit board 20 from power supplied from a power source unit 60, but electronic components to be cooled by the heat pipe 50 and the heat sink 60 are not limited to transistors, and the heat pipe 50 and the heat sink 60 may be used to cool a processor and a memory, for example.

FIG. 3 is a sectional view taken along line III-III in FIG. 1B. As depicted in FIG. 1B, the heat pipe 50 includes a heat reception portion 51 in a position away from the heat sink 60. As depicted in FIG. 3, the heat reception portion 51 of the heat pipe 50 is disposed between the circuit board 20 and the upper board shield 30. The heat reception portion 51 receives heat generated from the plurality of chips 21 mounted on the upper surface 20U of the circuit board 20 because the heat reception portion 51 is in contact with the chips 21. As depicted in FIG. 2, the plurality of chips 21 are arranged in the front-rear direction along the left edge 20L of the circuit board 20. The heat reception portion 51 extends in the front-rear direction so as to cover the plurality of chips 21. An auxiliary metal fitting 70 (see FIG. 5) is fitted to the heat reception portion 51. The auxiliary metal fitting 70 may be mounted on a lower surface 51D of the heat reception portion 51 by soldering or the like.

As depicted in FIG. 1B, the heat pipe 50 has, on a side opposite to the heat reception portion 51, a fit portion 52 to which the heat sink 60 is fitted. The fit portion 52 of the heat pipe 50 is disposed between the heat sink 60 and the upper board shield 30, and extends in the left-right direction. A recessed portion 61 (see FIG. 2) that is upwardly recessed is formed in the lower surface of the heat sink 60. The recessed portion 61 extends in the left-right direction, and the inner side of the recessed portion 61 is fitted to the fit portion 52 of the heat pipe 50.

The heat sink 60 is disposed on an air flow path that is formed in a housing accommodating the circuit board unit 10, and the heat sink 60 is cooled by air. Accordingly, the heat pipe 50 fitted to the heat sink 60 is cooled, and the plurality of chips 21 which are in contact with the heat reception portion 51 of the heat pipe 50 are also cooled. In this manner, the plurality of chips 21 are cooled.

An opening 32 (see FIG. 2) is formed in the upper board shield 30. FIG. 4 is a diagram depicting an area around the opening 32 in the upper board shield 30, and depicts the upper board shield 30 from which an auxiliary shield 80, which will be explained later, has been removed. A housing recessed portion 31 (see FIG. 3) in which the heat reception portion 51 of the heat pipe 50 is disposed, is formed in the lower surface (circuit board 20-side surface) of the upper board shield 30. The opening 32 is formed on the rear side of the housing recessed portion 31. As depicted in FIG. 2, the opening 32 is open in two directions which are the front-rear direction and the up-down direction. As depicted in FIG. 4, a recessed portion 32a that is rearwardly recessed is formed at the rear edge of the opening 32.

The heat pipe 50 extends from a space S (see FIG. 3) that is defined between the circuit board 20 and the housing recessed portion 31 of the upper board shield 30, to the outside (front side) of the upper board shield 30 through the opening 32, as depicted in FIGS. 1A and 2. Since the opening 32 is disposed in the upper board shield 30 and the heat pipe 50 extends to the outside of the upper board shield 30 through the opening 32 in this manner, the heat pipe 50 can extend to a direction away from the circuit board 20. Accordingly, the degree of freedom in layout of the electronic components mounted on the circuit board 20 can be increased.

In addition, since the opening 32 through which the heat pipe 50 passes is formed in the upper board shield 30, the size of an opening that is required to expose a cooling system including the heat sink 60, etc., to an area above the upper board shield 30, can be reduced. For example, to expose the heat sink 60 alone from the upper board shield 30, an opening that corresponds to the size of the heat sink 60 is required to be formed in the upper board shield 30. In contrast, in a structure in which the heat pipe 50 passes in the inside of the opening 32, the size of the opening 32 which is formed in the upper board shield 30 can be reduced. As a result of this downsizing of the opening 32, countermeasures against noise in the opening 32 can easily be taken.

FIG. 5 is a perspective view of the rear side (the lower side, the circuit board 20 side) of the upper board shield 30. As depicted in FIGS. 3 and 5, the housing recessed portion 31 that is upwardly recessed is formed in the lower surface 30D which is the rear surface of the upper board shield 30. In the position of the plurality of chips 21 mounted on the circuit board 20, the housing recessed portion 31 extends in the front-rear direction (which is along the Y axis). In the housing recessed portion 31, the heat reception portion 51 of the heat pipe 50 is disposed.

As depicted in FIG. 5, the auxiliary metal fitting 70 fitted to the heat reception portion 51 of the heat pipe 50 has a flat shape, and extends in the front-rear direction (which is along the Y axis) along the extension direction of the heat reception portion 51. The auxiliary metal fitting 70 includes a plurality of auxiliary heat reception portions 71 between the plurality of chips 21 and the lower surface 51D of the heat reception portion 51. The auxiliary heat reception portions 71 are disposed above the chips 21, and conduct heat received from the chips 21 to the heat reception portion 51. Since, in positions closer to the chips 21 than the heat reception portion 51 of the heat pipe 50, the auxiliary heat reception portions 71 disposed on the auxiliary metal fitting 70 receive heat from the chips 21 in this manner, heat can be more effectively adsorbed from the chips 21, whereby the chips 21 can be cooled. The auxiliary heat reception portions 71 may be brought into contact with the chips 21, and be fitted to the chips 21 by soldering or the like. In addition, a clearance C1 is formed between the adjacent auxiliary heat reception portions 71. Since the clearance C1 is disposed in this manner, the auxiliary metal fitting 70 and another electronic component (an electronic component which is not depicted but is disposed between the adjacent chips 21) mounted on the upper surface 20U of the circuit board 20 can be inhibited from interfering with each other.

In addition, as depicted in FIG. 5, a projected portion 72 that is rearwardly projected is formed on the rear end (Y2 direction-side end) of the auxiliary metal fitting 70. The projected portion 72 of the auxiliary metal fitting 70 is fitted in the recessed portion 32a which is formed in the rear edge of the opening 32 in the upper board shield 30. Since the projected portion 72 is formed on the rear end of the auxiliary metal fitting 70 and the recessed portion 32a is formed in the upper board shield 30 in this manner, the auxiliary metal fitting 70 and the upper board shield 30 can be easily positioned on the rear end of the auxiliary metal fitting 70. Moreover, at the rear end of the auxiliary metal fitting 70, the auxiliary metal fitting 70 and the heat reception portion 51 of the heat pipe 50 fitted to the auxiliary metal fitting 70 can be inhibited from moving along the lower surface 30D of the upper board shield 30.

Further, as depicted in FIG. 5, a guide hole 73 is formed in the front end (Y1 direction-side end) of the auxiliary metal fitting 70, and a projected portion 38 that is downwardly projected is formed on the lower surface 30D of the upper board shield 30. The guide projected portion 38 of the upper board shield 30 is fitted in the guide hole 73 in the auxiliary metal fitting 70, so that the auxiliary metal fitting 70 and the upper board shield 30 can be easily positioned on the front end of the auxiliary metal fitting 70. With the abovementioned guide projected portion 38 and the guide hole 73, the position of the auxiliary metal fitting 70 on the upper board shield 30 can be defined in the front-rear direction and the left-right direction. With the projected portion 72 on the auxiliary metal fitting 70 and the recessed portion 32a in the upper board shield 30, the position of the auxiliary metal fitting 70 can be defined in a rotation direction around the guide projected portion 38.

In addition, as depicted in FIG. 3, a fitting projected portion 74 that is upwardly projected is formed on the front end (more specifically, the front side of the guide hole 73) of the auxiliary metal fitting 70. A fitting hole 39 is formed in the upper board shield 30. The fitting projected portion 74 which is upwardly projected is fitted into the fitting hole 39 in the upper board shield 30, and is formed into a flange shape. Thus, the fitting projected portion 74 is caught on an edge of the fitting hole 39. Accordingly, the front end of the auxiliary metal fitting 70 can be mounted on the upper board shield 30.

The fitting projected portion 74 of the auxiliary metal fitting 70 is formed by performing sheet metal processing of pushing the auxiliary metal fitting 70 upwardly. Therefore, a recessed portion 75 that is larger than the fitting projected portion 74 in a plan view is formed on a side, of the auxiliary metal fitting 70, opposite to the fitting projected portion 74. Moreover, the fitting projected portion 74 is formed into a flange shape by pressing the top of the fitting projected portion 74 downwardly, and is caught on an edge of the fitting hole 39 in the upper board shield 30, whereby the fitting projected portion 74 is fixed in the fitting hole 39 in the upper board shield 30.

### [1-3. Noise countermeasures using auxiliary shield]

As depicted in FIG. 2, the circuit board unit 10 includes the auxiliary shield 80. A recessed portion 81 that is upwardly recessed is formed in the auxiliary shield 80. Like the board shields 30 and 40, the auxiliary shield 80 may be produced by performing sheet metal processing on a conductive metal sheet including iron, aluminum, or the like. As depicted in FIGS. 1A and 2, the auxiliary shield 80 is fitted to the upper board shield 30, and covers the opening 32 formed in the upper board shield 30. Since the opening 32 in the upper board shield 30 is covered with the auxiliary shield 80 in this manner, leakage of noise from the opening 32 to the outside of the upper board shield 30 can be suppressed.

As depicted in FIG. 2, a guide recessed portion 33 that is downwardly recessed along an outer edge of the auxiliary shield 80 is formed in the upper surface 30U of the upper board shield 30. Since the guide recessed portion 33 is formed in the upper board shield 30, the auxiliary shield 80 can easily be positioned on the upper board shield 30, whereby fitting the auxiliary shield 80 is facilitated. In addition, an outer recessed portion 34 that is downwardly recessed along the heat pipe 50 is formed in the upper surface 30U of the upper board shield 30. Since the heat pipe 50 is disposed in the outer recessed portion 34, the heat pipe 50 can be inhibited from moving along the upper surface 30U of the upper board shield 30. In addition, since the outer recessed portion 34 is formed, necessity to bend the heat pipe 50 upwardly in order to bring the heat pipe 50 above the upper board shield 30 is eliminated. As a result, the shape of the auxiliary shield 80 covering the opening 32 and the heat pipe 50 at the periphery of the opening 32 can be simplified.

As depicted in FIG. 4, the heat pipe 50 includes a passing portion 53 passing through the opening 32 from the outside of the upper board shield 30. The auxiliary shield 80 covers the passing portion 53 of the heat pipe 50 in the plan view in FIG. 4. Outside the upper board shield 30, the passing portion 53 of the heat pipe 50 is disposed between the guide recessed portion 33 in the upper board shield 30 and the auxiliary shield 80.

FIG. 6 is a plan view of the auxiliary shield 80. It is to be noted that, in FIG. 6, the position of the opening 32 in the upper board shield 30 covered with the auxiliary shield 80 is indicated by a dotted line. As depicted in FIG. 6, the recessed portion 81 which is upwardly recessed in the auxiliary shield 80 is formed along the passing portion 53 of the heat pipe 50. Accordingly, a gap between the auxiliary shield 80 and the heat pipe 50 is narrowed, so that leakage of noise from an area between the auxiliary shield 80 and the heat pipe 50 can be suppressed.

As depicted in FIGS. 2 and 4, in the upper board shield 30, the outer recessed portion 34 is at least partially formed in the guide recessed portion 33. As depicted in FIG. 4, the front end of the outer recessed portion 34 is connected to the opening 32 which is formed inside the guide recessed portion 33. Accordingly, a gap between the upper board shield 30 and the heat pipe 50 can be narrowed at an edge of the opening 32, so that leakage of noise from an area between the upper board shield 30 and the heat pipe 50 can be suppressed.

As depicted in FIG. 6, the auxiliary shield 80 includes a fixation portion 82 that is fixed to the upper board shield 30 via a fixing tool such as a screw or a rivet. In addition, as depicted in FIG. 4, the upper board shield 30 also includes a fixation portion 36 that is fixed to the auxiliary shield 80 via a fixing tool. The fixation portions 36 and 82 may be holes that are formed in the same position in a plan view of the circuit board unit 10, and one fixing tool may be fitted into these holes. For example, if the auxiliary shield 80 and the upper board shield 30 are fastened together with one screw, the auxiliary shield 80 comes, at the position of the fixation portions 36 and 82, into contact with the upper board shield 30. The noise cutoff performance can be improved in the position of the fixation portions 36 and 82 at which the auxiliary shield 80 is in contact with the upper board shield 30 in this manner.

FIG. 7 is a sectional view taken along line VII-VII in FIG. 1B, and depicts a cross section of the upper board shield 30 and the auxiliary shield 80. As depicted in FIGS. 4 and 7, the upper board shield 30 has, in the guide recessed portion 33, a projected portion 37 that is upwardly projected. The projected portion 37 (first projected portion) may be formed by performing sheet metal processing on the upper board shield 30. Accordingly, the projected portion 37 can be easily formed on the upper board shield 30. Alternatively, the projected portion 37 may be formed by putting a conductive member such as a solder on the guide recessed portion 33 in the upper board shield 30.

As depicted in FIGS. 6 and 7, the auxiliary shield 80 includes a contact portion 83 that is in contact with the upper board shield 30 via the projected portion 37. The auxiliary shield 80 may be warped with respect to the upper board shield 30, so that the contact portion 83 of the auxiliary shield 80 is stably in contact with the projected portion 37. In order to generate this warping, it is desirable that the auxiliary shield 80 is softer than the upper board shield 30 on which a projected portion 62 is formed. In the example depicted in FIG. 7, the up-down direction thickness of the auxiliary shield 80 is smaller than the thickness of the upper board shield 30. Alternatively, the auxiliary shield 80 may include a material (e.g. aluminum) that is softer than the material (e.g. iron) of the lower board shield 40. Since the projected portion 37 and the contact portion 83 are disposed in this manner, the stability of contact between the upper board shield 30 and the auxiliary shield 80 can sufficiently be ensured, so that the noise cutoff performance can be improved at the position of the projected portion 37 and the contact portion 83.

As depicted in FIG. 6, the auxiliary shield 80 includes, on at least one of the left side and the right side of the passing portion 53, the fixation portion 82 which is fixed to the upper circuit board shield 30 and the contact portion 83 which is separated from the fixation portion 82 in the front-rear direction (which is along the Y axis) which is the extension direction of the passing portion 53 of the heat pipe 50. In other words, the upper circuit board shield 30 includes, on at least one of the left side and the right side of the heat pipe 50, the fixation portion 36 which is fixed to the auxiliary shield 80 and the projected portion 37 which is in contact with the auxiliary shield 80. The auxiliary shield 80 includes, on at least one of the left side and the right side of the passing portion 53 of the heat pipe 50, two fixation portions 82, and the upper circuit board shield 30 includes two fixation portions 36 in the same positions as the two fixation portions 82 in a plan view. Between the two fixation portions 82 (fixation portions 36), the projected portion 37 and the contact portion 53 are formed.

In the example depicted in FIG. 6, the auxiliary shield 80 includes, on each of the left side and the right side of the passing portion 53 of the heat pipe 50, the fixation portions 82 and the contact portion 83. In addition, the upper board shield 30 includes, on each of the left side and the right side of the passing portion 53, the fixation portions 36 and the projected portion 37. Alternatively, on the auxiliary shield 80, the fixation portion 82 and the contact portion 83 may be formed on either one of the left side and the right side of the passing portion 53 while only the fixation portion 82 may be formed on the other side. In like manner, on the upper board shield 30, the fixation portion 36 and the projected portion 37 may be formed on either one of the left side and the right side of the heat pipe 50 while only the fixation portion 36 may be formed on the other side.

On each of the left side and right side of the heat pipe 50, a distance d1 between the fixation portion 82 and the contact portion 83 formed on the auxiliary shield 80 (that is, the distance d1 between the fixation portion 36 and the projected portion 37 formed on the upper board shield 30) is desirably determined on the basis of the wavelength of noise to be inhibited from leaking to the outside of the upper board shield 30. The distance d1 may be set to be less than one third of the wavelength of noise to be shielded by the upper board shield 30 and the auxiliary shield 80, or more preferably, may be set to be less than one fourth of the wavelength. For example, if the distance d1 is set to 20 mm or less, leakage of noise in a frequency band that is used for wireless communication or the like can effectively be suppressed. More preferably, the distance d1 may be set to 15 mm or less. Still more preferably, the distance d1 may be set to 10 mm or less.

In the example depicted in FIG. 6, the fixation portions 82 are formed on four corners of the front left side, the rear left side, the front right side, and the rear right side of the auxiliary shield 80. In positions corresponding to the four fixation portions 82, four fixation portions 36 of the upper board shield 30 are formed. The projected portion 37 and the contact portion 83 are disposed between the two fixation portions 82 positioned on each of the front left corner and the rear left corner, and between the remaining two fixation portions 82 positioned on each of the front right corner and the rear right corner. It is to be noted that, in the example depicted in FIG. 6, one projected portion 37 and one contact portion 83 are disposed between each two fixation portions 82. However, two or more projected portions 37 and two or more contact portions 83 may be disposed between each two fixation portions 82.

FIG. 8 is a schematic diagram depicting a cross section of the upper board shield 30 and the auxiliary shield 80 in another example of the present embodiment. FIG. 8 is a diagram schematically depicting a cross section obtained along the front-rear direction passing through the fixation portions 36 and 82, the projected portion 37, and the contact portion 83.

As depicted in FIG. 8, at the position of the fixation portion 36, the auxiliary shield 80 comes into contact with the upper board shield 30 by being pressed by a fixation portion H such as a screw against the upper board shield 30. Then, when the auxiliary shield 80 is warped with respect to the upper board shield 30, the contact portion 83 of the auxiliary shield 80 may come into contact with the projected portion 37.

Here, when the contact portions 83 is lifted up by the projected portions 37, the auxiliary shield 80 may be warped upwardly and a clearance C2 may be accordingly formed between the two projected portions 37. If three projected portions 37 are formed between two fixation portions 36 on the upper board shield 30, there is a possibility that one of the three projected portions 37 between the remaining two projected portions 37 is positioned near the clearance C2. For this reason, it is desirable that the number of the projected portions 37 disposed between the adjacent two fixation portions 36 is two or less. In other words, it is desirable that the number of the contact portions 83 disposed between the two adjacent fixation portions 82 on the auxiliary shield 80 is two or less. Accordingly, the stability of contact between the upper board shield 30 and the auxiliary shield 80 is sufficiently ensured, so that the performance of cutting off noise that is generated on the circuit board 20 can be improved.

The passing portion 53 (see FIG. 4) of the heat pipe 50 extends from the space S (see FIG. 3) between the circuit board 20 and the upper board shield 30, and passes through the opening 32 to the rear side (first direction) from the outside of the upper board shield 30. As depicted in FIG. 6, the recessed portion 81 in the auxiliary shield 80 includes a first overlapping portion 81B that is positioned on the rear side of the opening 32 in the upper board shield 30 and covers the passing portion 53 of the heat pipe, and a second overlapping portion 81F that is positioned on the front side (which is opposite to the first direction) of the opening 32 and covers the passing portion 53 of the heat pipe 50. A width D1 of the first overlapping portion 81B in the front-rear direction is larger than a width D2 of the second overlapping portion 81F in the front-rear direction.

Noise that is generated from electronic components such as the chips 21 mounted on the upper surface 20U of the circuit board 20 is radiated to a direction away from the electronic components. Thus, the noise is radiated from the opening 32 (see FIG. 4) in the upper board shield 30 to the rear side. For this reason, as depicted in FIG. 6, the width D1 of the overlap between the auxiliary shield 80 and the heat pipe 50 on the rear side of the opening 32 is set to be larger than the width D2 of the overlap between the auxiliary shield 80 and the heat pipe 50 on the front side of the opening 32. Accordingly, noise radiated to the rear side of the opening 32 can be more effectively shielded.

In addition, as depicted in FIG. 6, in the recessed portion 81 in the auxiliary shield 80, the first overlapping portion 81B covering the heat pipe 50 is slightly bent along an outer edge of the heat pipe 50 toward the right direction (X2 direction). Accordingly, noise such as an electromagnetic wave going straight to the rear side from the opening 32 (see FIG. 4) in the upper board shield 30 can easily be reflected, so that the noise cutoff performance can be improved.

### [1-4. Conclusion]

As described so far, the heat pipe 50 of the present embodiment extends from the space S between the circuit board 20 and the upper board shield 30 to the outside of the upper circuit board shield 30 through the opening 32 formed in the upper board shield 30. Accordingly, the heat pipe 50 can extend to a direction away from the circuit board 20, and the degree of freedom in layout of the electronic components mounted on the circuit board 20 can be increased.

In addition, in the present embodiment, the auxiliary shield 80 is fitted to the upper board shield 30, and covers the opening 32 formed in the upper board shield 30. Accordingly, leakage of noise from the opening 32 to the outside of the upper board shield 30 can be suppressed.

It is to be noted that the present invention is not limited to the embodiment described above.

FIG. 9 is a plan view of the auxiliary shield 80 in another example of the present embodiment. Also in the example depicted in FIG. 9, the auxiliary shield 80 includes the fixation portion 82 that is fixed to the upper circuit board shield 30, and the contact portion 83 that is in contact with the projected portion 37 on the upper circuit board shield 30. The auxiliary shield 80 includes two contact portions 83 on at least one of the left side and the right side of the heat pipe 50, and the fixation portion 82 is formed between the two contact portions 83. That is, the upper board shield 30 includes two projected portions 37 on at least one of the left side and the right side of the heat pipe 50, and the fixation portion 36 is provided between the two projected portions 37. On either one of the left side and the right side of the heat pipe 50, the two projected portions 37 are disposed separately from each other in the front-rear direction (which is along the Y axis), and the two contact portions 83 are also disposed separately from each other in the front-rear direction. The fixation portions 36 and 82 are formed between the two projected portions 37 (between the two contact portions 83) which are disposed separately from each other in the front-rear direction. Also in this case, the stability of contact between the upper board shield 30 and the auxiliary shield 80 can sufficiently be ensured, so that the noise cutoff performance can be improved.

Also in this case, a distance d2 between the fixation portion 82 and the contact portion 83 formed on the auxiliary shield 80 (that is, the distance d2 between the fixation portion 36 and the projected portion 37 formed on the upper board shield 30) is desirably determined on the basis of the wavelength of noise to be inhibited from leaking to the outside of the upper board shield 30. The distance d2 may be set to be less than one third of the wavelength of noise to be shielded by the upper board shield 30 and the auxiliary shield 80, or more preferably, may be set to be less than one fourth of the wavelength. For example, if the distance d2 is set to 20 mm or less, leakage of noise in a frequency band that is used for wireless communication or the like, can effectively be suppressed. More preferably, the distance d2 may be set to 15 mm or less. Still more preferably, the distance d2 may be set to 10 mm or less.

### [2. Second embodiment]

FIG. 10 is a plan view of a part of a circuit board unit 100 that is disposed inside an electronic device which is another example of an embodiment of the present disclosure (second embodiment). Like the circuit board unit 10 described above, the circuit board unit 100 also includes an upper board shield 130 (first circuit board shield), and a circuit board and a lower board shield (second circuit board shield) which are not depicted. The circuit board is disposed between the upper board shield 130 and the lower board shield. The upper board shield 130 and the lower board shield are provided to suppress leakage of noise such as an electromagnetic wave generated on the circuit board to the outside of the circuit board unit 100.

The upper board shield 130 covers a first surface (upper surface) of the circuit board. The lower board shield covers a second surface (lower surface) of the circuit board. The upper board shield 130 and the lower board shield are fixed to the circuit board via a fixing tool such as a screw or a rivet. The upper board shield 130 depicted in FIG. 10 also can be produced by performing sheet metal processing such as drawing processing on a conductive metal sheet including iron, aluminum, or the like.

Also, the circuit board unit 100 includes a heat pipe 150 extending into a rod-like shape along the circuit board and the upper board shield 130, and a heat sink (not depicted) fitted to the heat pipe. The heat pipe 150 and the heat sink include metal such as aluminum, copper, or stainless having high heat conductivity, and are used to cool electronic components such as chips and FETs mounted on the circuit board.

As depicted in FIG. 10, the circuit board unit 100 includes an auxiliary shield 180 that is fitted to the upper board shield 130. FIG. 11 depicts a plan view of the auxiliary shield 180 alone. A recessed portion 181 that is upwardly recessed is formed in the auxiliary shield 180. A part of the heat pipe 150 is housed in the recessed portion 181. Like the upper board shield 130 and the second board shield, the auxiliary shield 180 may be produced by performing sheet metal processing on a conductive metal sheet including iron or aluminum.

FIG. 12 is a plan view of the upper board shield 130 from which the auxiliary shield 180 has been removed. As depicted in FIG. 12, an opening 132 is formed in the upper board shield 130. The opening 132 is open in two directions which are the front-rear direction and the up-down direction. In addition, a recessed portion 132a that is rearwardly recessed is formed at the rear edge of the opening 132.

The heat pipe 150 extends from a space that is defined between the circuit board and the lower side (rear side) of the upper board shield 130 to the upper side (front side) of the upper board shield 130 through the opening 132. Accordingly, the heat pipe 150 can extend to a direction away from the circuit board. The degree of freedom in layout of electronic components mounted on the circuit board can be increased. In addition, compared to a case where an opening corresponding to the size of the heat sink is formed in the upper board shield 130, the size of the opening 132 can be reduced. As a result, countermeasures against noise in the opening 132 can easily be taken.

FIG. 13 is a sectional view taken along line XIII-XIII in FIG. 10. FIG. 14 is a sectional view taken along line XIV-XIV in FIG. 10. FIG. 15 is a sectional view taken along line XV-XV in FIG. 10. As depicted in FIG. 13, an outer recessed portion 134 that is downwardly recessed along the heat pipe 150 is formed in the upper surface 130U of the upper board shield 130. Since the heat pipe 150 is disposed in the outer recessed portion 134, the heat pipe 150 can be inhibited from moving along the upper surface 130U of the upper board shield 130. In addition, a gap between the upper board shield 130 and the heat pipe 150 can be narrowed, so that leakage of noise from an area between the upper board shield 130 and the heat pipe 150 can be suppressed.

As depicted in FIGS. 10 and 12, the auxiliary shield 180 covers the opening 132 formed in the upper board shield 130 while being fitted to the upper board shield 130. Accordingly, leakage of noise from the opening 132 to the outside of the upper board shield 130 can be suppressed. Like the heat pipe 50 described above, the heat pipe 150 also has a passing portion 153 passing through the opening 132 in the upper board shield 130, as depicted in FIG. 15. The auxiliary shield 180 covers the passing portion 153 of the heat pipe 150. On the upper side of the upper board shield 130, the passing portion 153 of the heat pipe 150 is disposed between the upper board shield 130 and the auxiliary shield 180. Also in the auxiliary shield 180, the recessed portion 181 which is upwardly recessed is formed along the passing portion 153 of the heat pipe 150. As a result, a gap between the auxiliary shield 180 and the heat pipe 150 can be narrowed, so that leakage of noise from an area between the auxiliary shield 180 and the heat pipe 150 can be suppressed.

As depicted in FIG. 11, the auxiliary shield 180 includes a fixation portion 182 that is fixed to the upper board shield 130. Further, as depicted in FIG. 12, the upper board shield 130 also includes a fixation portion 136 that is fixed to the auxiliary shield 180.

As depicted in FIGS. 13 and 14, the fixation portions 136 and 182 are formed in the same position in a plan view of the circuit board unit 100. In the present embodiment, the fixation portion 182 is a hole formed in the auxiliary shield 180, and the fixation portion 136 is a projected portion projected upwardly (toward the auxiliary shield 180) from the upper surface of the upper board shield 130. The fixation portion 136 of the upper board shield 130 is fitted into the hole of the fixation portion 182 in the auxiliary shield 180, and then, swaging processing (crushing the fixation portion 136 in the up-down direction) is performed, whereby the fixation portion 136 is formed into a flange shape. The fixation portion 136 of the upper board shield 130 is caught on an edge of the hole of the fixation portion 182. Accordingly, the auxiliary shield 180 is fixed to the upper board shield 130. In addition, in the position of the fixation portions 136 and 182, the auxiliary shield 180 is in contact with the upper board shield 130. Accordingly, the noise cutoff performance can be improved at the position of the fixation portions 136 and 182.

It is to be noted that, like the fixation portion 182 of the auxiliary shield 180, the fixation portion 136 of the upper board shield 130 may be a hole. In this case, one fixing tool may be fitted in the holes of the fixation portions 136 and 182. For example, if the auxiliary shield 180 and the upper board shield 130 are fastened together with one screw, the auxiliary shield 180 comes, at the position of the fixation portions 136 and 182, into contact with the upper board shield 130. Also with this configuration, the noise cutoff performance can be improved at the position of the fixation portions 136 and 182.

Like the upper board shield 30 which has been described in the first embodiment, the upper board shield 130 includes a projected portion 137 (first projected portion, see FIG. 12) that is upwardly projected. The projected portion 137 may be formed by performing sheet metal processing on the upper board shield 130, or may be formed by putting a conductive member such as a solder on the upper board shield 130. The auxiliary shield 180 includes a contact portion 183 (see FIG. 11) that is in contact with the upper board shield 130 via the projected portion 137. Since the upper board shield 130 and the auxiliary shield 180 are in contact with each other at the position of the projected portion 137 and the contact portion 183, the noise cutoff performance can be improved at the position of the projected portion 137 and the contact portion 183.

In the example depicted in FIGS. 10 and 12, the upper board shield 130 includes, on each of the left side and the right side of the passing portion 153 of the heat pipe 150, the fixation portion 136 and the projected portion 137. In addition, the auxiliary shield 180 includes, on each of the left side and the right side of the passing portion 153, the fixation portion 182 and the contact portion 183. On each of the left side and the right side of the passing portion 153, a distance d3 between the fixation portion 182 and the contact portion 183 formed on the auxiliary shield 180 (the distance d3 between the fixation portion 136 and the projected portion 137 formed on the upper board shield 130) is desirably determined on the basis of the wavelength of noise to be inhibited from leaking to the outside of the upper board shield 130. The distance d3 may be set to be less than one third of the wavelength of noise to be shielded, or more preferably, may be set to be less than one fourth of the wavelength. For example, if the distance d3 is set to 20 mm or less, leakage of noise in a frequency band that is used for wireless communication or the like can effectively be suppressed. More preferably, the distance d3 may be set to 15 mm or less. Still more preferably, the distance d3 may be set to 10 mm or less.

On the auxiliary shield 180 depicted in FIG. 11, the fixation portions 182 are formed on four corners of the front left side, the front right side, the rear left side, and the rear right side of the auxiliary shield 180. In positions corresponding to the four fixation portions 182, four fixation portions 136 of the upper board shield 130 are formed. In addition, a projected portion 185 (second projected portion, see FIG. 13) that is downwardly projected is formed between the front-left fixation portions 82 and the front-right fixation portion 182 of the auxiliary shield 180. Also, a projected portion 186 (third projected portion, see FIG. 13) that is downwardly projected is provided between the rear-left fixation portion 182 and the rear-right fixation portion 182 of the auxiliary shield 180. For example, the projected portions 185 and 186 may be formed by performing sheet metal processing on the auxiliary shield 180. The upper surface (front surface) of the auxiliary shield 180 may have recesses in the positions for the projected portions 185 and 186. Alternatively, the projected portions 185 and 186 may be formed by putting conductive members such as solders on the auxiliary shield 180.

As depicted in FIGS. 10 and 13, on the front side of the auxiliary shield 180, the projected portion 185 which is downwardly projected is in contact with the heat pipe 150 (more specifically, the passing portion 153). Since the projected portion 185 is formed on the auxiliary shield 180, the stability of contact between the auxiliary shield 180 and the heat pipe 150 can be ensured at the position of the projected portion 185, and the noise cutoff performance can be improved at the position of the projected portion 185. Moreover, as depicted in FIGS. 10 and 14, on the rear side of the auxiliary shield 180, the projected portion 186 which is downwardly projected is in contact with the upper board shield 130. Since the projected portion 186 is formed on the auxiliary shield 180, the stability of contact between the auxiliary shield 180 and the upper board shield 130 can be ensured at the position of the projected portion 186, and the noise cutoff performance can be improved also at the position of the projected portion 186.

It is to be noted that the auxiliary metal fitting 70 (see FIG. 13) which has been described in the first embodiment may be mounted on the lower side of the heat pipe 150. In addition, in place of the projected portion 185 (see FIG. 13) on the auxiliary shield 180, a projected portion (second projected portion) may be formed on the heat pipe 150 (more specifically, the passing portion 153), and the auxiliary shield 180 and the heat pipe 150 may be in contact with each other via this projected portion. The projected portion on the heat pipe 150 may be formed by putting a conductive member such as a solder on the heat pipe 150. Moreover, in place of forming the projected portion 186 on the auxiliary shield 180 (see FIG. 14), a projected portion (third projected portion) may be formed on the upper board shield 130 (more specifically, the rear side of the opening 132 in the upper board shield 130), and the auxiliary shield 180 and the upper board shield 130 may be in contact with each other via this projected portion. The projected portion on the upper board shield 130 may be formed by performing sheet metal processing on the upper board shield 130, or may be formed by putting a conductive member such as a solder on the upper board shield 130.

Since the auxiliary shield 180 is warped with respect to the upper board shield 130, the contact portion 183 and the projected portion 186 on the auxiliary shield 180 can be stably in contact with the upper board shield 130. In addition, since the auxiliary shield 180 is warped, the projected portion 185 on the auxiliary shield 180 can be stably in contact with the heat pipe 150. In order to generate this warping, the thickness of the auxiliary shield 180 may be set to be smaller than the thickness of the upper board shield 130, or the auxiliary shield 180 may include a material (e.g. aluminum) that is softer than the material (e.g. iron) of the lower board shield 40, for example. Accordingly, the stability of contact between the auxiliary shield 180 and the upper board shield 130 can sufficiently be ensured at the contact portion 183 and the projected portion 186, and the stability of contact between the auxiliary shield 180 and the heat pipe 150 can sufficiently be ensured at the projected portion 185, so that the noise cutoff performance can be improved at the positions of the contact portion 183 and the projected portions 185 and 186.

A distance d4 (see FIG. 11) between the fixation portion 182 and the projected portion 185 formed on the front side of the auxiliary shield 180, and a distance d5 (see FIG. 11) between the fixation portion 182 and the projected portion 186 formed on the rear side of the auxiliary shield 180, are desirably determined on the basis of the wavelength of noise to be inhibited from leaking to the outside of the upper board shield 130. Each of the distances d4 and d5 may be set to be less than one third of the wavelength of noise to be shielded, or more preferably, may be set to be less than one fourth of the wavelength. For example, if each of the distances d4 and d5 is set to 20 mm or less, leakage of noise in a frequency band that is used for wireless communication or the like can effectively be suppressed. More preferably, each of the distances d4 and d5 may be set to 15 mm or less. Still more preferably, the distance d1 may be set to 10 mm or less.

As depicted in FIG. 12, an elastic member 190 having electric conductivity is disposed on the upper side of the upper board shield 130. As depicted in FIG. 15, the elastic member 190 is disposed between the upper board shield 130 and the heat pipe 150. In the example depicted in FIG. 15, the elastic member 190 is pressed in the up-down direction by the upper board shield 130 and the heat pipe 150. With a reaction force from the elastic member 190, the heat pipe 150 is pressed against the lower surface (rear surface) of the auxiliary shield 180. Accordingly, the stability of contact between the heat pipe 150 and the projected portion 185 which is downwardly projected from the lower surface of the auxiliary shield 180 can be more reliably ensured, so that the noise cutoff performance can be further improved at the position of the projected portion 185.

As described above, the heat pipe 150 of the present embodiment also extends to the outside of the upper circuit board shield 130 through the opening 132 formed in the upper board shield 130. Further, the auxiliary shield 180 is fitted to the upper board shield 130, and covers the opening 132 formed in the upper board shield 130. Accordingly, leakage of noise from the opening 132 to the outside of the upper board shield 130 can be suppressed.

## Claims

1. An electronic device comprising:
a circuit board;
a circuit board shield covering the circuit board;
a heat pipe disposed between the circuit board and the circuit board shield; and
an auxiliary shield, wherein
an opening is formed in the circuit board shield,
the heat pipe extends from a space between the circuit board and the circuit board shield to an outside of the circuit board shield through the opening, and
the auxiliary shield is fitted to the circuit board shield, and covers the opening.

2. The electronic device according to claim 1, wherein
the auxiliary shield includes, on at least one side of the heat pipe, at least one fixation portion that is fixed to the circuit board shield via a fixing tool, and at least one contact portion that is separated, in an extension direction of the heat pipe, from the at least one fixation portion and that is in contact with the circuit board shield via a first projected portion.

3. The electronic device according to claim 1, wherein
the auxiliary shield includes, on each side of the heat pipe, at least one fixation portion that is fixed to the circuit board shield via a fixing tool, and at least one contact portion that is separated, in an extension direction of the heat pipe, from the at least one fixation portion and that is in contact with the circuit board shield via a first projected portion.

4. The electronic device according to claim 2 or 3, wherein
the auxiliary shield includes two fixation portions as the at least one fixation portion, and
the at least one contact portion is formed between the two fixation portions.

5. The electronic device according to claim 2 or 3, wherein
the auxiliary shield includes two contact portions as the at least one contact portion, and
the at least one fixation portion is formed between the two contact portions.

6. The electronic device according to claim 1, wherein,
in a first direction, the heat pipe extends from the space between the circuit board and the circuit board shield to the outside of the circuit board shield through the opening,
the auxiliary shield includes a first overlapping portion that is positioned in the first direction from the opening and that covers the heat pipe, and a second overlapping portion that is positioned in a direction opposite to the first direction from the opening and that covers the heat pipe, and
a width of the first overlapping portion in the first direction is larger than a width of the second overlapping portion in the first direction.

7. The electronic device according to claim 2 or 3, wherein
a distance between the at least one fixation portion and the at least one contact portion is less than one third of a wavelength of noise to be shielded by the auxiliary shield.

8. The electronic device according to claim 1, wherein
either one of the auxiliary shield and the heat pipe includes a second projected portion that is in contact with the other one.

9. The electronic device according to claim 8, wherein
the auxiliary shield includes at least one fixation portion that is fixed to the circuit board shield via a fixing tool, and
a distance between the at least one fixation portion and the second projected portion is less than one third of a wavelength of noise to be shielded by the auxiliary shield.

10. The electronic device according to claim 1, wherein
either one of the auxiliary shield and the circuit board shield includes a third projected portion that is separated, in an extension direction of the heat pipe, from the opening and that is in contact with the other one.

11. The electronic device according to claim 10, wherein
the auxiliary shield includes at least one fixation portion that is fixed to the circuit board shield via a fixing tool, and
a distance between the at least one fixation portion and the third projected portion is less than one third of a wavelength of noise to be shielded by the auxiliary shield.
